Europäisches Patentamt

European Patent Office

Office européen des brevets

(19)

(11) Publication number: **0 263 221**
**A1**

(12) # EUROPEAN PATENT APPLICATION

(21) Application number: **86430036.3**

(22) Date of filing: **08.10.86**

(51) Int. Cl.4: **H01L 21/48**

(43) Date of publication of application:
**13.04.88 Bulletin 88/15**

(84) Designated Contracting States:
**DE FR GB IT**

(71) Applicant: **International Business Machines Corporation**
**Old Orchard Road**
**Armonk, N.Y. 10504(US)**

(72) Inventor: **Beaudouin, Pierre**
**31 Rue Guerin**
**F-77300 Fontainebleau(FR)**
Inventor: **Grandguillot, Michel Joseph**
**18, Allée des Fraisiers**
**F-91370 Verrières le Buisson(FR)**
Inventor: **Bitaillou, Alexis**
**15, rue du Vercors**
**F-91220 Bretigny Sur Orge(FR)**

(74) Representative: **Klein, Daniel Jacques Henri**
**Compagnie IBM France Département de Propriété Intellectuelle**
**F-06610 La Gaude(FR)**

(54) **Method of forming solder bumps on metal contact pads of a substrate.**

(57) Disclosed is a method of forming solder bumps (21) on an electrically insulating substrate (10) provided with a plurality of minute metal contact pads (15) according to a grid pattern at the center or the said substrate characterized in the steps of first applying a droplet of flux to any contact pad where desired, applying a solder preform to the said previously fluxed pad to which it will adhere because the adhesive property of the flux, heating to cause a solder reflow of the solder preform and cooling below the melting point of the solder whereby the molten solder solidifies to form the said solder bumps.

FIG.4

# METHOD OF FORMING SOLDER BUMPS ON METAL CONTACT PADS OF A SUBSTRATE

## Technical Field

The present invention relates to the solder bonding of electronic modules to metallized bodies and more particularly to a method of forming solder "bumps" on metal contact pads of Multilayer Ceramic (MLC) modules for direct and easy surface mounting onto metallized substrates such as Printed Circuit Boards (PCB's) or Printed Wiring Boards (PWB's).

## Background of the Invention

Multilayer Ceramic (MLC) is an advanced packaging technology developed by the applicant, which significantly improves the module circuit density, reliability and performance over those of previous packages. A key element in this powerful package is the MLC substrate, which is capable of supporting more than 100 semiconductor chips in some design uses. The manufacturing of the MLC substrate has been widely documented, e.g. in an article entitled "A Multilayer Ceramic Multichip Module", published in the IEEE Transactions on Components, Hybrids and Manufacturing Technology, vol. CHMT-4, No. 4, December 1980, pp 634-637. After sintering, the MLC substrate is processed through a series of plating steps to provide the required nickel and gold metallization to form input/output (I/O) metal contact pads for subsequent brazing. A contact pad is round-shaped and very small: its thickness is about 2.2 microns and diameter is about 2 mm, with a center to center distance from its nearest neighbor of approximately 2.54 mm. After electrical test, nickel plated Kovar nail-shaped pins are brazed to the said contact pads using a low temperature noble metal braze. The semiconductor chips, which are terminated in lead tin (Pb/Sn) solder bumps are placed with the bumps down on the top or main surface of the MLC substrate according to the well known "Flip Chip" technique, and the assembly is reflowed in a furnace. After electric test, a plated Kovar cap is seam welded to the metallized band which surrounds the chip site area on the top surface, to achieve a completed MLC module.

One of the problems associated with MLC technology is related to these nail-shaped pins. Their handling, their automatic placement on the said I/O metal contact pads, still remain a problem and are a serious detractor of manufacturing yields. In addition, it is difficult to reduce the diameter of contact pads because of the brazing of the heads of the nail shaped pins, which necessitate a minimum contact surface. Also, these pins require perforated PCB's, i.e. those provided with plated via-holes to receive the pins before bonding. Perforated PCB's are costly and a considerable area is lost due to the presence of the plated via-holes. Generally the diameter of the elongated part of the pins before tinning is about .6 mm, while the plated via-holes in the PCB have a diameter of about 1 mm. Due to the internal construction of the PCB, it is almost impossible to reduce the standard center to center distance of 2.54 mm. If the use of nail-shaped pins can be avoided, the diameter of contact pads could be reduced to less than 1 mm, e.g. .7 mm and the center to center distance to less than 1.27 mm, therefore considerably increasing the number of I/O's permitted on the same surface of the PCB. But increasing the permissable pins also has its problems as the number of pins increases, inserting the module into the PCB becomes more difficult, with an increasing likelihood of having pins bent during this step. Also, when pins are used as I/O's, the module comes in close contact with the PCB, leaving no clearance between the two unless a costly standoff (separator) is provided which also reduces the cooling efficiency of the module. Another problem is that the use of modules having pins as I/O's, in combination with perforated PCB's, prevents bonding MLC modules on both sides of the PCB's. Still another problem raised by the use of such a great number of pins is the difficulty of reworking the module to make engineering changes. However this technology is still highly appreciated mainly because it provides a relatively great number of I/O's, useful for present and future VLSI chip packaging.

On the other hand, today's packaging techniques are evolving towards the extensive use of Surface Mount Techniques (SMT) in order to improve the density of circuits at the card level and reduce the cost of packaging. In SMT technology, modules are directly bonded to the desired metal lands of the PCB.

Commonly used Surface Mount modules such as those mentioned above are provided with peripheral I/O's. In this case the I/O's consist of metal leads bent under the bottom surface of the module that come into contact with the metal lands formed at the surface of the PCB. The cost of these modules becomes rapidly prohibitive when the number of I/O's increases to a high count (typically: 100 to 300) because of the amount of area required.

For example, for a given technology, doubling the number of pins leads to a fourfold increase in module area with a similar loss of card area, and a degradation of the module electrical characteristics (inductances, resistances...) which in turn results in parasitic effects.

On the contrary, it is obvious that a module with I/O's placed on a gridded pattern would be more efficient in terms of handling large number of I/O's; for example, an increase of I/O count by a factor of two, will result in a more reasonable factor of two for the module area. The system designer would then be able to take a full advantage of the card density and optimization, and thus cost as well as electrical performances would be significantly improved.

As a matter of fact, a pinless MLC module having I/O's placed according to a gridded pattern at the center of the bottom surface (opposite to said top surface) of the MLC substrate or even occupying the whole bottom surface, would be a highly desirable solution in all respects.

The type of I/O's that could be imagined to be used on such MLC substrates might consist of solder bumps located on the bottom of the ceramic at the locations of the said minute contact pads. In order to form these solder bumps, one solution could be the evaporation of lead (Pb) and tin (Sn) through a metal mask, or a lift-off technique such the one described in an article "Small thick solder pad formation" published in the IBM Technical Disclosure Bulletin, Vol. 27, No. 12, May 1985, pp 7267-7268, both techniques are commonly used in standard silicon processing to produce chips.

Usually these solder bumps after reflow when used for silicon chips exhibit an approximately hemispheric shape. The dimensions of the bumps are about 130 $\mu$m in height and about 100 $\mu$m in diameter. The bump to bump spacing is in the 200-350 $\mu$m range. Although the MLC contact pads are very small, their size is significantly wider than the Ball Limiting Metallurgy (BLM) of Cr-Cu-Au which forms the base of the chip solder bumps.

Various experiments have been conducted by the applicant and have demonstrated that a change of dimensions of the grid size and solder volume leads to costly manufacturing (due to low yields), and to poor control of the bump geometry (shape/volume/height) with an obvious impact on reliability.

Another solution could be found in an article entitled: "Pretinning the Metallurgy of a Module to Enhance Wettability" by B. Pottier et al and published in the IBM Technical Disclosure Bulletin, Vol. 20, No. 2, July 1977 pp 622-623. The aim is to tin contact pads formed over a MLC substrate such as those referenced 12 in Fig. 1 of the present application. According to that reference, the flux is dispensed on the whole surface of the substrate before dispersing tiny solder balls thereon. After solder reflow, the metal pads are tinned with solder. As a result, very thin solder bumps are created at the top of the said metal pads. In addition to an obvious insufficient volume of solder, the deposition of the flux on the whole surface of the substrate is an unacceptable source of contamination. Lastly, it is a non selective process as all the metal pads are tinned.

Therefore there still exists a need for a method of forming solder bumps onto contact pads, at desired locations according to a gridded pattern (or an array) of a metallized body, typically an MLC substrate.

## Summary of the Invention

The foregoing problems are solved by using the method of this invention, whose characteristics are defined by claim 1. As a consequence, pins are no longer used as I/O's but are replaced by solder bumps formed onto the contact pads deposited at desired locations of the bottom surface of the MLC substrate. According to a particular embodiment of the invention, it is described a method of forming a pinless module appropriate for Surface Mounting Techniques to be bonded onto Printed Circuit Boards (PCB's). The method is comprised of the following steps: applying a droplet of flux to any contact pad where desired; applying a solder preform, typically a solder ball, to the previously fluxed pad to which it will adhere because of the adhesive property of the flux; heating to cause a solder reflow of the solder preform; and, cooling below the melting point of the solder so that the molten solder solidifies to form the said solder bumps.

Details of the method are disclosed in the subclaims.

A primary advantage of the method of this invention is to produce pinless (or leadless) electronic modules, typically MLC modules where all the problems related to the pin handling, pin brazing and pin inserting, in addition to the use of perforated PCB's, are alleviated, thereby allowing such a pinless electronic module to fully comply with SMT requirements.

Another advantage of the method of this invention is to provide a MLC substrate provided with solder bumps permitting easy repair and rework.

Another advantage of the method of this invention is to provide a MLC substrate having solder bumps formed on the metal contact pads according to a very dense grid pattern, either at the center of the bottom surface of the MLC substrate or on the whole surface of the latter.

Another advantage of the method of this invention is to provide solder terminals to MLC substrates terminated with solder bumps to be bonded to the corresponding metallization lands of a PCB by forming solid solder joints.

Yet another advantage of the method of this invention is to provide a solder joint between the MLC substrate and the metallization lands of a PCB having non negligible height to improve the cooling of the MLC module.

A further advantage of the method of this invention is its flexibility in the tight control of the dimensions and the nature of the solder bumps, by using solder balls of different volumes and compositions.

A further advantage of the method of this invention is its ability to be easily installed in any manufacturing line, and to produce reliable products with high production.

These and other advantages of this invention will appear more fully upon consideration of the various examples, now described in detail in connection with the accompanying drawings which form a material part of this disclosure.

Brief Description of the Drawings

Fig. 1 is a perspective view in broken section of a conventional MLC substrate schematically showing a typical internal conductive network including wiring planes, fan out wiring planes, etc., after the nickel/gold plating step.

Figs. 2 to 4 are cross sectional views of the substrate of Fig. 1, during various steps of fabrication in accordance with the preferred embodiment of the method of the present invention.

It should be appreciated that for purposes of illustration, these figures are not necessarily drawn to scale.

Detailed Description

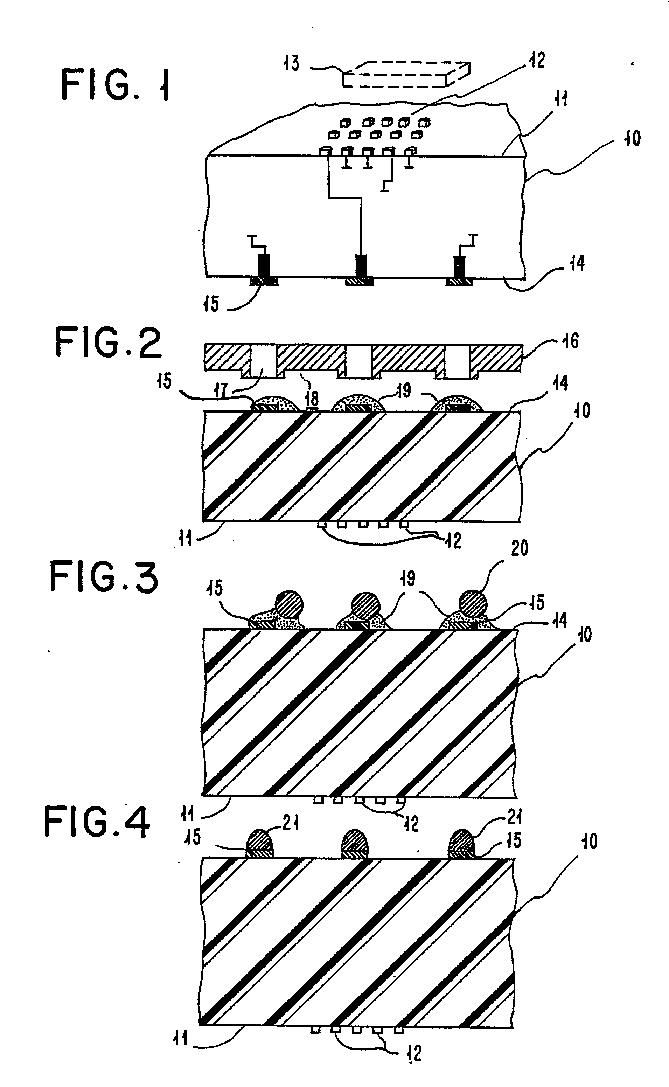

Fig. 1 of the drawings shows illustrated a typical laminated multi-layer ceramic substrate 10 in which the concept of the present invention can be applied. The substrate 10 can be of any suitable size to accommodate the desired number of devices. The devices on the substrate can be of the order of 100 or more. In Fig. 1, all of the device sites for joining devices to the surface are not shown in the interest of reducing drawing complexity. Typically, device sites would be arranged in columns and rows, to form an array with typically 10 columns arranged in 10 rows, making a total of 100 devices. Substrate 10 has an internal circuitry, made up of a plurality of laminated and sintered layers with via holes and printed circuits. The material of the substrate 10 is chosen for good mechanical, electrical and thermal properties so that the thermal expansion is a reasonably close match to the silicon material of the devices to be mounted on the top surface of the substrate.

The top surface 11 of substrate 10 is provided with a plurality of metal pads 12, disposed according to a first grid pattern, and adapted to be joined to a corresponding pattern of solder bumps of a semiconductor chip 13. It will be appreciated that various patterns can be imagined. An asymmetrical pattern permits joining the chip 13 in only one correct position.

At the bottom surface 14 of substrate 10, the geometry of the vias internal lines and therefore of the contact pads 15 is larger and corresponds more to the spacing of the conventional nail shaped pins. Those contact pads 15 form a second grid pattern, substantially wider than said first grid pattern existing at the top surface. As explained previously, in conventional MLC substrates, those contact pads are usually comprised of a composite metal layer such as nickel/gold obtained by plating. They are round shaped: diameter is about 2 mm and of about 2.2 microns in thickness (2 microns for the Ni layer and .2 microns for the Au layer).

The method of this invention will now be described with reference to Figs. 2 to 4. The technique described thereafter is based on US Patent No. 4 462 534 entitled "Method of Bonding Connecting Pins to the Eyelets of Conductors Formed on a Ceramic Substrate", issued to A. Bitaillou et al and assigned to the same assignee as of this invention. A minor improvement thereof has been published in the IBM Technical Disclosure Bulletin, vol. 27, No. 10B, March 1985, pp 6252-6253, in an article entitled: "Ball Placement Improvement for Untinned Substrate Process" by A. Bitaillou et al. Both disclosures, are incorporated by reference herein, the main steps of which are briefly summarized below. Only the significant differences between the method of this invention and the earlier disclosed techniques will be detailed.

The first step of the process consists in dispensing droplets of flux to be applied onto the contact pads. The flux dispensing device - schematically shown in Fig. 2 of US Patent 4 462 534 is appropriate to reduce to practice the method of the present invention. According to the latter, a flux, such as: Benzylic 102-1500 manufactured by the Alpha Metals Co. with a viscosity of about 200 poises is appropriate. The flux is contained in a Teflon tank housed in a stainless steel cylinder whose removable bottom, consisting of a wire cloth, forms a fluxing mask. The holes in the mask are arranged in a pattern corresponding to the pattern of metal contact pads. The flux will be forced to flow through these holes during the dispense step. The pressure within the tank is established by a vacuum system controlled, for example, by a logic circuit or by the analog output from a processor. The MLC substrate is positioned onto a support fitted with locating pins. The flux remains in the tank while the latter is being positioned over the substrate and aligned therewith, and is then released by means of an air pulse supplied by the vacuum system. Because of the flatness of the surface to be fluxed, and in order to avoid the spreading of the flux on the mask by capillarity, a particular shape is given to the bottom surface of the mask 16 as shown in Fig. 2 of the present application. Each hole (flux output) 17 is terminated in a pipe-shaped form. With such a design, the wetting of the flux on the mask (by capillarity) will be reduced to the region of interest because the flux spreading is prevented.

A simple way to achieve such a result consists in separating each hole of a standard mask by a saw line drawn according to both rows and columns to form grooves 18 between holes. After removal of the device, there remains a droplet of flux 19 on the location of each metal contact pad 15. It has been found that, assuming the use of metal contact pads of 0.7 mm in diameter, a spacing of 0.1 mm between the mask and the pads is desirable. Under these conditions, the holes 17 should have a diameter of 0.4 mm and the metal sheet constituting the fluxing mask should have a thickness of 1 mm.

Success in covering the contact pad with an evenly dispensed droplet of flux was unexpected, due to the small size, and extreme thinness of the contact pad (about 2.2 microns). This problem was not encountered in the dispense of a droplet of flux above the pin head as described in US Patent 4 462 534 because of the relatively important elevation of the pin head, about .6 mm which, by creating a kind of relief, allows the droplet of flux to stick to it.

The second step consists in using the other devices also described in US Patent 4 462 534 to cause a solder ball to be dispensed and applied to any metal contact pads where desired, to which it will then adhere because of the adhesive capacity of the droplet of flux deposited thereon during the first step.

The solder balls selected for this application are about 0.7 mm in diameter and the solder is an alloy of Pb-Sn (90/10). In view of their light weight, the solder balls should be agitated before they are drawn by suction. To this end, the solder balls are initially placed in a bowl that is caused to vibrate using a vibrating device as shown in Fig. 4A of US Patent 4 462 534. The bowl should be made of some elastic material so as to allow the balls to bounce. Polyethylene was found to be quite satisfactory for this purpose. The vibrations alone proved insufficient to cause the solder balls to bounce. The optimum number of solder balls to be placed in the bowl was determined to correspond to a single layer of solder balls at the bottom of the bowl when not vibrated. In the preferred embodiment mentioned earlier, the bowl is a parallelepiped with a square base (70 mm $\times$ 70 mm) and a height of 80 mm. The vibrating device comprises a plate resting on two oblique springs and an electromagnet which causes said plate to vibrate.

Under the above conditions, the bouncing solder balls reached a height of about 20 mm. Other means could of course be employed for vibrating the solder balls, such as a container having a porous bottom and receiving compressed air.

Referring now to Fig. 4B of US Patent 4 462 534, there is shown a suction device which sucks up the moving solder balls contained in the vibrating bowl and dispenses them on the previously fluxed substrate. The device comprises a soft iron frame which may be of circular shape and defines a suction chamber connected by a tube to a controlled vacuum system. An electromagnet surrounds the said tube and is fed from a main supply (50 Hz) through a diode. The suction chamber is closed by a suction mask fitted with a rod whose far end is located within the air gap of the electromagnet. The mask consists of a perforated membrane 0.1 mm in thickness that is made of an alloy of beryllium and copper. The holes in the membrane are 0.4 mm in diameter and correspond to the pattern of metal contact pads on the MLC substrate.

The operation of the devices shown in Figs. 4A and 4B of US Patent 4 462 534 is as follows. The device is first operated to cause the solder balls in the bowl to vibrate. The device previously connected to the vacuum source, is then inserted in the vibrating bowl such that the distance between the suction mask and the bottom of the bowl is about 5 mm. The time necessary for all the solder balls to be sucked up is of the order of 1 second. The suction device, including the mask with which the solder balls are maintained in contact by the vacuum, is then removed from the bowl and positioned over the substrate so that the pattern of solder balls and the pattern of pins are aligned; however, it does not matter if the patterns are only slightly offset with respect to each other. It is just necessary to ensure that each ball lies over at least a portion of the corresponding metal pad. The patterns may be aligned through the use of locating pins provided on the support on which the electronic module rests and which fit into matching cavities in the frame of the device. The solder balls are thus brought into contact with the corresponding droplets of flux. The vacuum system is then turned off, and the electromagnet is energized for about half a second to cause the membrane to vibrate. As a result, the solder balls separate more easily from the membrane while continuing to adhere to the metal pads because of the flux thereon.

Fig. 3 illustrates the configuration of the solder balls on the MLC substrate 10 and clearly shows that in some instances, a slight offset between the metal contact pad 15 and the solder ball 20 may happen.

In the third step, the ceramic substrate is introduced in a conventional furnace or oven, containing a reducing atmosphere such as nitrogen, to prevent oxidation and having a peak temperature in the range of about 200°C to 350°C, and the time the solder is above its melting point is about 15-60 seconds, depending on the solder composition, to cause solder reflow, thereby and forming the solder bumps to be used as I/O's of the MLC module. Even if the solder ball is slightly offset with respect to the contact pad, the resulting solder bump is perfectly aligned with it. All solder bumps exhibit uniform geometries and volumes.

The substrate is then allowed to cool below the melting point of the solder, so that the molten solder will solidify to produce solid solder bumps. Fig. 4 illustrates the MLC substrate after cooling showing the metal contact pads 15 having provided thereon solder bumps 21.

This third step is then followed by a fourth step, consisting in the cleaning of the resulting MLC substrate, such as by dipping the MLC substrate in a perchlorethylene bath, in order to degrease the substrate and eliminate flux residuals.

The bottom surface of the MLC module may be then visually inspected to detect missing solder bumps. In this case, rework is very easy because it is sufficient to add flux at the missing location, place solder bumps and reflow again. Other solder bumps will not flow or spread due to very high capillarity forces.

The chip may be bonded to the MLC substrate either simultaneously with the formation of solder bumps, or subsequently. If the chips are to be joined simultaneously with the formation of solder bumps, it suffices to dispense droplets of flux to be applied onto the contact fingers at the ends of the conductors to correspond to the solder balls on the silicon chips, and position the chips. Reflow temperatures, reflow times, relative volumes of solder, and solder compositions are parameters which have to be considered to the man skilled in the art depending on the specific application involved.

The MLC substrate is then processed according to the standard manufacturing steps: test, encapsulation, etc... to provide a completed pinless MLC module appropriate for SMT.

Surface mounting of the carrier on a printed circuit board (not shown) would comprise depositing solder paste (e.g., 60% Sn and 40% Pb) on predetermined contact zones of the PCB, aligning and contacting the solder bumps of the module with such zones and reflowing the 60/40 solder at 185°C. The PCB is preferably of the multilayer type and is provided with a corresponding grid of copper pads of a diameter of about 0,6 MM. The PCB is covered by a layer of a protective varnish excepted at the pad locations. Use of solder paste and protective varnish avoids misalignment problems. However, if any difficulty is raised, the use of a template to maintain the module where appropriate would overcome the problem. On the other hand, the technique described for the pre-tinning of said zones in the afore mentioned Pottier's reference, may alaso be used.

As can be understood, a significant advantage of the method of this invention from a manufacturing point of view is its simplicity. Another advantage is the flexibility of the above method which is easily adapted to any kind of module, application,...., etc., because a wide variety of solder balls in both size and composition is commercially available; and because the solder ball has a very precise volume.

Replacing pins to be inserted in plated viaholes of a perforated PCB, by solder bumps results in lower costs and increased packaging densities.

This invention provides a method of getting a controlled amount of solder at each bonding location. Depending the volume of the solder ball, the shape and in particular the height of the solder bump may vary in some respect. This causes an important additional related advantage. Because the volume of the solder ball determines the height of the solder joint obtained after cooling, it has generally the broad shape of a column or pillar, so that the gap between the bottom surface of the MLC module and the top surface of the PCB's is no longer negligable. As a consequence, this gap contributes significantly, not only to the air cooling of the module, but also to the reduction of thermal stresses due to differences in thermal dilatation coefficients between the substrate and the PCB material.

It is also obvious that the replacement of pins by solder bumps results in a significant increase in the ability to repair or rework the MLC module. In particular, as explained above, it is easy to rework the MLC substrate if visual inspection has revealed a contact pad without a solder bump.

It is also significant that this invention allows the formation of solder bumps at the center of an MLC module according to a denser grid pattern, thereby resulting in a significant increase of I/O integration. It must be observed that the method of this invention allows the use of all the bottom surface of the MLC substrate if desired, and not only the periphery of the substrate as in known techniques.

The method of this invention is applicable to any pinless or leadless module, such as MLC module, ... or any surface mounted devices or any type of component device not having terminal wires or pins for insertion through plated holes in a perforated PCB. Also, the method of this invention is not limited to circular metal contact pads so typical of the MLC technology, but also to other types of contact pads. Other known types of modules such as PLCC or LCCC, can also benefit from some or all of the advantages provided by the method of this invention.

## Claims

1. A method of forming solder bumps (21) on an electrically insulating substrate (10) provided with a plurality of minute metal contact pads (15) according to a grid pattern of said substrate (10) characterized in the steps of first applying a droplet of flux (19) to any contact pad (15) where desired, applying a solder preform (20) to the said previously fluxed pad to which it will adhere because of the adhesive property of the flux, heating to cause a solder reflow of the solder preform and cooling to below the melting point of the solder whereby the molten solder solidifies to form the said solder bumps (21).

2. The method of claim 1 including further the step of cleaning to eliminate flux residuals.

3. The method of claim 1 or 2 wherein the step of applying a droplet of flux consists in forcing the flux through a mask (16) having pipe-shaped holes (17).

4. The method of claim 1, 2 or wherein the said solder preform is a solder ball.

5. The method of claim 4 wherein the solder ball has a diameter of about .7 mm and comprises 90% by weight lead and 10% by weight tin.

6. The method of any above claim wherein the said metal contact pads forming the said grid pattern occupy the whole surface of the said insulating substrate.

7. The method of any above claim wherein the said insulating substrate (10) consists of a MLC substrate and the said contact pads are circular and formed by a nickel/gold plating.

FIG. 1

FIG. 2

FIG. 3

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,Y | EP-A-0 082 902  (IBM) <br> * Claims 1,4; page 6, paragraph 2 * | 1 | H 01 L  21/48 |
| A | | 3-6 | |
| Y | GB-A-2 138 339  (WELWYN) <br> * Page 2, lines 86-120 * | 1 | |
| A | | 2 | |
| A | EP-A-0 171 662  (IBM) <br> * Abstract; claim 30; figure  11A * | 7 | |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 29-05-1987 | DE RAEVE R.A.L. |